# EUROPÄISCHE PATENTSCHRIFT

(11) **EP 2 901 709 B1**
(45) Veröffentlichungstag und Bekanntmachung des Hinweises auf die Patenterteilung: **09.11.2016**
(21) Anmeldenummer: 13762431.8
(22) Anmeldetag: 09.09.2013
(51) Int. Cl.: H04Q 9/00, H01M 10/42, H01M 10/48, B60L 3/00, B60L 11/18, G01R 31/36

(54) **VERFAHREN ZUR DATENÜBERMITTLUNG AN BATTERIESYSTEMEN MIT MEHREREN ZELLEN**
METHOD FOR DATA TRANSMISSION ON BATTERY SYSTEMS HAVING A PLURALIY OF CELLS
PROCÉDÉ DE TRANSMISSION DE DONNÉES À DES SYSTÈMES DE BATTERIES COMPRENANT PLUSIEURS ÉLÉMENTS

(30) Priorität: 26.09.2012 DE 102012217369
(43) Veröffentlichungstag der Anmeldung: 05.08.2015
(73) Patentinhaber: Robert Bosch GmbH, 70442 Stuttgart (DE)
(72) Erfinder: POEHLER, Joerg, 70825 Korntal-Muenchingen (DE)
(86) Internationale Anmeldenummer: PCT/EP2013/068576
(87) Internationale Veröffentlichungsnummer: WO 2014/048704

(56) Entgegenhaltungen:
- US-A- 4 564 798
- US-A1- 2012 106 663

## Beschreibung

Die vorliegende Erfindung betrifft Akkumulatortechnologie in Fahrzeugen. Insbesondere betrifft die vorliegende Erfindung ein Verfahren zur Datenübermittlung an Batteriesystemen mit mehreren Zellen. Weiter insbesondere betrifft die vorliegende Erfindung ein Verfahren zur Messdatenübermittlung von Zellen eines Batteriesystems mit einer Mehrzahl von Einzelzellen an ein Steuergerät, ein Batteriesystem, ein Steuergerät sowie ein Fahrzeug, insbesondere Elektro- oder Hybridfahrzeug mit einem erfindungsgemäßen Batteriesystem und/oder Steuergerät zur Ausführung des erfindungsgemäßen Verfahrens.

### Stand der Technik

Heutige Batteriesysteme, zum Beispiel Traktionsbatterien im Automobilbereich, sind aus sicherheits- und/oder informationstechnischen Gründen mit einem Batteriemanagementsystem versehen. Ein derartiges Batteriemanagementsystem (BMS) bezieht Messdaten von einzelnen Zellen sowie Gesamtbatteriemessgrößen und vermag hieraus unter anderem einen aktuellen Batterieladezustand sowie Prognosen der Leistungsfähigkeit einer Batterie bezüglich Laden und Entladen zu bestimmen, insbesondere für von einem Fahrzeughauptsteuergerät angeforderte Zeiträume. Weiterhin finden Berechnungsalgorithmen Verwendung, die die Alterung einzelner Batteriezellen detektieren und für die zuvor genannten Algorithmen aktuelle Batterieparameter ermitteln.

Ein derartiges Batteriemanagementsystem ist aus der Patentschrift US4564798 bekannt. 1f

Eine erste Bedatung der bzw. Parameterermittlung für die Ladezustands- und Leistungsvorhersagealgorithmen erfolgt anhand von hochgenauen Messdaten für Strom und Spannung einzelner Zellen bzw. der gesamten Batterie aus Prüfstandsmessungen an den einzelnen Batteriezellen. Nach einer Verbauung in einem Fahrzeug unterliegen die Zellen jedoch einer zeitabhängigen Alterung. Diese wiederum muss online im Fahrzeug erkannt werden, um eine Neuparametrierung aufgrund der Zellalterung durchführen zu können.

Um eine Neuparametrierung hoher Qualität durchführen zu können, werden schnelle Abtastungen für die Einzelzellspannungen sowie dem dabei auftretenden Strom durchgeführt. Bevorzugt erfolgt eine Abtastung mit einem Zeitfenster von <50 ms, beispielsweise in einem 1 ms-Intervall, um einen Spannungseinbruch durch einen Ohmschen Widerstand exakt zu detektieren. Für eine bevorzugte Neuparametrierung kann eine synchrone Abtastung der Einzelzellspannungen sowie des zugehörigen Stroms gewählt werden.

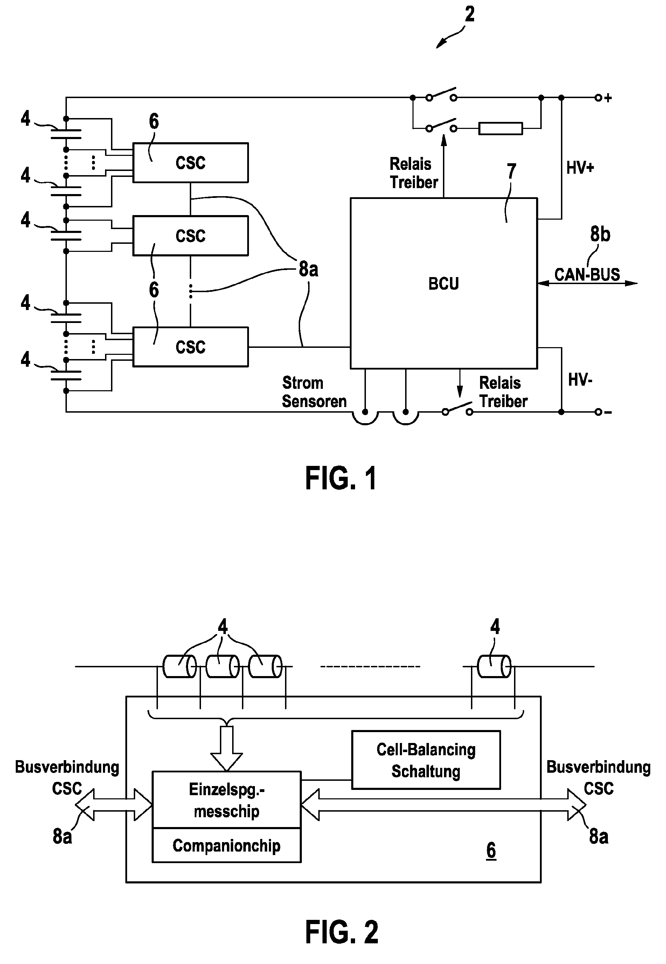

Figur 1 zeigt eine exemplarische Ausgestaltung einer Hardwarearchitektur eines herkömmlichen Batteriemanagementsystems.

Figur 1 weist hierbei eine Mehrzahl von Einzelzellen 4 auf, welche in bekannter Weise mit einem CSC-Element (Cell Supervision Circuit) 6 verbunden sind. Die einzelnen CSC-Elemente 6 sind untereinander und mit dem BCU-Element (Battery Control Unit) 7 über einen Datenbus 8a verbunden. Das BCU-Element 7 kann verschiedene Sensoren wie beispielsweise Strommesssensoren angebunden haben und mit Relaistreibern Relais des Batteriesystems 2 ansteuern. Das Batteriemanagementsystem ist exemplarisch unter Verwendung eines fahrzeuginternen Kommunikationsbusses 8b, beispielsweise eines CAN-Busses, mit weiteren Steuergeräten im Fahrzeug verbunden.

Die Messung von Einzelspannungen der einzelnen Zellen 4 übernimmt dabei das jeweilige CSC-Element 6, welches mit der- oder den Einzelzellen 4 verbunden ist. Die Anbindung der CSC-Elemente 6 erfolgt über den Datenbus 8a zum Batteriemanagementsystem-Hauptsteuergerät, dem BCU-Element 7.

Figur 2 zeigt eine exemplarische Ausgestaltung eines CSC-Elementes.

Eine Einzelspannungsmessung einer Einzelzelle 4 erfolgt dabei in der Regel über ein spezielles Bauelement des CSC-Elementes 6, welches die Spannungen der Einzelzellen 4, in der Regel sechs oder zwölf Einzelzellen 4, erfasst, diese Messwerte analog/digital wandelt unter Verwendung von einem oder mehreren A/D-Wandlern im Einzelspannungsmesschip und diese ermittelten Messwerte unter Verwendung des Bussystems 8a zur Batteriemanagementsystem-Hauptplatine, dem BCU-Element 7, sendet. Ein solches CSC-Element 6 kann im Weiteren noch eine Mehrzahl von Temperaturmessstellen aufweisen.

Meist ist aus Sicherheitsgründen im CSC-Element 6 noch ein sogenannter Companionchip vorgesehen, welcher eine Grenzwertüberwachung bezüglich der Zellspannungen durchführen kann. Im Weiteren kann im CSC-Element 6 noch ein Cell-Balancing Element vorgesehen, um ein Cell-Balancing der von ihm gemessenen Zellen durchzuführen bzw. die zugehörigen Halbleiterschalter ansteuern zu können. Cell-Balancing ist hierbei aus dem Stand der Technik bekannt und insbesondere relevant zum Ausgleich von (unterschiedlichen) State of Charge (SoC) Zuständen einzelner Zellen 4, welche zu einem Gesamtpaket verbunden sind.

Je mehr Zellen zu einem Batteriesystem zusammengeschaltet werden, insbesondere je mehr CSC-Elemente 6 unter Verwendung eines einzelnen seriellen Busses miteinander verkoppelt werden, ergibt sich eine immer weiter steigende Belastung des Kommunikationsbusses 8a aufgrund der Tatsache, dass einzelne CSC-Elemente 6 ihre Messwerte unabhängig voneinander generieren und nachfolgend über den Kommunikationsbus 8a übertragen möchten. Dies kann je nach Ausbaustufe eines solches Systems zur vollständigen Füllung oder sogar Überlastung des Datenbusses 8a führen.

### Offenbarung der Erfindung

Ein Aspekt der vorliegenden Erfindung kann darin gesehen werden, ein Verfahren zur Messdatenübermittlung von Zellen eines Batteriesystems bereitzustellen, bei dem ein geringer Datenübermittlungsaufwand für die Übermittlung von Ladezustands- und Leistungsvorhersagealgorithmen benötigter Daten auftritt.

Demgemäß wird ein Verfahren zur Messdatenübermittlung von Zellen eines Batteriesystems mit einer Mehrzahl von Einzelzellen an ein Steuergerät; ein Batteriesystem sowie ein Steuergerät, welche eingerichtet sind zum Durchführen des erfindungsgemäßen Verfahrens sowie ein Fahrzeug, insbesondere ein Elektro- oder Hybridfahrzeug mit einem solchen Batteriesystem und/oder Steuergerät gemäß der unabhängigen Ansprüche angezeigt. Bevorzugte Ausgestaltungen ergeben sich aus den abhängigen Ansprüchen.

Das erfindungsgemäße Verfahren stellt hierbei eine kostengünstige Möglichkeit dar, unter Berücksichtigung einer Buslast dieser Systeme die Erweiterbarkeit bzw. die Skalierbarkeit eines Batteriemanagementsystems zu erhöhen.

Bekannte Systeme weisen meist eine begrenzte Erweiterbarkeit auf, da je länger eine Kette aus CSC-Elementen wird, desto mehr erhöht sich die Buslast aufgrund der steigenden Zellanzahl sowie der deshalb von den CSC-Elementen auf den Bus gelegten Datenpaketen. Herkömmlich werden nun zur Kompensation die Abtastzeiten verlangsamt bzw. die Abtastintervalle der Einzelzellspannungen erhöht, was jedoch eine Verringerung der Messwertqualität bzw. Datenqualität insbesondere einer Onlineparameterermittlung nach sich zieht. Werden Batterieparameter nicht mehr ausreichend oft und genau ermittelt, reduziert dies die Aussagekräftigkeit einer Ladezustandsermittlung und Leistungsprognosealgorithmen.

Das erfindungsgemäße Verfahren bemüht hierbei ein sogenanntes "cell focussing" Verfahren, das ein Überladen eines Datenbusses bei ansonsten unveränderten Busparametern reduzieren oder verhindern mag. Das erfindungsgemäße System sieht vor, dass bestimmte Einzelzellen an einem CSC-Element mit einer hohen Abtastrate, vergleichbar einer solchen an einem initialen Prüfstand, zum Beispiel 1 ms, abgetastet werden. Ebenso schnell kann auch eine Stromabtastung erfolgen. Zumindest einer dieser Messwerte kann geeignet analog vorgefiltert werden.

Ein Aspekt der vorliegenden Erfindung besteht nun darin, dass eine bestimmte Einzelzelle fokussiert, somit zur Analyse ausgewählt wird. Gleichzeitig bedeutet dies, dass auch das entsprechende CSC-Element, an dem diese Zelle angebunden ist, fokussiert bzw. ausgewählt wird. Fokussiert heißt in diesem Zusammenhang, dass die Messdaten mit einer ersten Qualität, insbesondere einer hohen Qualität bzw. hohen Häufigkeit generiert und dabei insbesondere im Wesentlichen vollständig und unverzögert auf einen Datenbus gelegt werden.

Dadurch ist zunächst sichergestellt, dass die fokussierte Zelle ihre Messdaten im Wesentlichen unverzögert und vollständig an ein BCU-Element eines BMS-Systems übermitteln kann und nicht von einer Buskapazität eingeschränkt wird. Die Messdaten der weiteren Zellen, somit derjenigen Zellen bis auf die fokussierte Zelle, werden verzögert bzw. möglicherweise unvollständig auf den internen Bus geschrieben, möglicherweise unter Verwendung einer geeigneten digitalen Vorfilterung im CSC-Element. Dieser langsamere Raster des "auf den internen Bus Schreibens" der nicht fokussierten Zellen kann beispielsweise derart ausgestaltet sein, dass nicht sämtliche Messdaten einer nichtfokussierten Zelle, welche durch ein CSC-Element generiert wurde, übertragen werden, sondern nur beispielsweise jeder zehnte, jeder 100ste oder jeder 1000ste Wert. Diese Messdaten werden im Weiteren als solche mit einer zweiten Qualität bezeichnet.

Demgegenüber werden die Messdaten erster Qualität der fokussierten Einzelzelle so schnell wie möglich, insbesondere so schnell, wie die Abtastung ausgeführt werden kann, auf den Bus gelegt. So schnell wie möglich ist in diesem Zusammenhang unter Berücksichtigung einer möglichen Datenaufbereitung und -verarbeitung im CSC-Element zu verstehen. Für eine besonders bevorzugte Parameteridentifikation wird die Messung eines Stromes, welcher die fokussierte Einzelzelle belastet, sowie der Messung der an ihr anliegenden Spannung zeitlich synchronisiert. Eine derartige Synchronisierung kann beispielsweise über eine von der BMS-Hauptplatine ausgesendete Taktbotschaft erreicht werden, mit welcher sich die fokussierte Einzelzelle bzw. deren fokussiertes CSC-Element sowie der Stromsensor synchronisiert.

Im Rahmen der vorliegenden Erfindung werden zwei Qualitätsstufen von Messdaten unterschieden, eine erste Qualität sowie eine zweite Qualität, wobei die erste Qualität eine höhere Qualität bzw. Qualitätsstufe aufweist als die zweite Qualität bzw. Qualitätsstufe. Eine erste Qualität bzw. eine hohe Qualitätsstufe beinhaltet, dass eine Zelleinzelspannung einer fokussierten Einzelzelle schnell und insbesondere zeitsynchron mit dem Strom zu dieser Zelle abgetastet wird, beispielsweise in einem 1ms-Raster. Die zweite Qualität bzw. niedrigere Qualitätsstufe mag sich dabei auf die restlichen Einzelspannungen der restlichen Einzelzellen beziehen, welche langsamer und möglicherweise bereits digital gefiltert in einem langsameren Raster, zum Beispiel in einem 1s-Raster bzw. von Multiplexbotschaften zum Beispiel eines CAN-Busses, übertragen werden. Ein einzelner Messwert zweiter Qualität muss dabei nicht zwangsläufig schlechter sein als ein solcher erster Qualität, insbesondere in Bezug auf Auflösung und Genauigkeit des Messwertes.

Über einen bestimmten Zeitraum wird nun an einer fokussierten Einzelzelle eine Onlineparameteridentifikation durchgeführt. Dieser Zeitraum kann einerseits durch ein zeitliches Limit begrenzt sein, vorzugsweise jedoch durch ein Limit auf Basis der Konvergenz der zu identifizierenden Batterieparameter. In anderen Worten wird eine derartige Parameteridentifikation solange durchgeführt, bis aufeinanderfolgende Parameterwerte sich nur noch derart unterscheiden, dass Unterschied bzw. das Δ. der Parameterwerte eine definierte Grenze unterschreitet. Ist die Messung einer aktuell fokussierten Zelle aufgrund dieses Zeitraumes abgeschlossen, kann die nächste Einzelzelle wie zuvor beschrieben fokussiert werden, somit für eine synchronisierte Strom- und Spannungsmessung selektiert werden.

Auch kann eine solche fokussierte Messung durch einen Plausibilitätscheck ausgelöst werden, welcher bei Betrachtung der normalen Messdaten, somit der Messdaten der zweiten Qualität, einen nicht standardkonformen Vorgang detektiert. Derartige Plausibilitätschecks können beispielsweise eine Spannung sowie einen zugehörigen Strom berücksichtigen, welche regelmäßig nicht gemeinsam auftreten oder auch einen bestimmten, zum Beispiel erhöhten Temperaturgradienten einer Einzelzelle als Auslöser für eine Selektion verwenden. Wird somit ein ungewöhnlicher Betriebszustand bei einer bestimmten Einzelzelle aufgrund der Messwerte zweiter Qualität detektiert, kann diese Zelle ausgewählt und mit dem erfindungsgemäßen Verfahren, somit in schnellem Raster, beobachtet werden, um gegebenenfalls geeignete Maßnahmen gegen die Fehlfunktion der Einzelzelle auslösen zu können.

Ausführungsformen der Erfindung sind in den Zeichnungen dargestellt und in der nachfolgenden Beschreibung näher erläutert.

Es zeigen
Figur 1 eine exemplarische Ausgestaltung einer Hardwarearchitektur eines herkömmlichen Batteriemanagementsystems;
Figur 2 eine exemplarische Ausgestaltung eines CSC-Elementes; und
Figur 3 eine exemplarische Ausgestaltung einer Datenbuskommunikation gemäß der vorliegenden Erfindung.

### Ausführungsformen der Erfindung

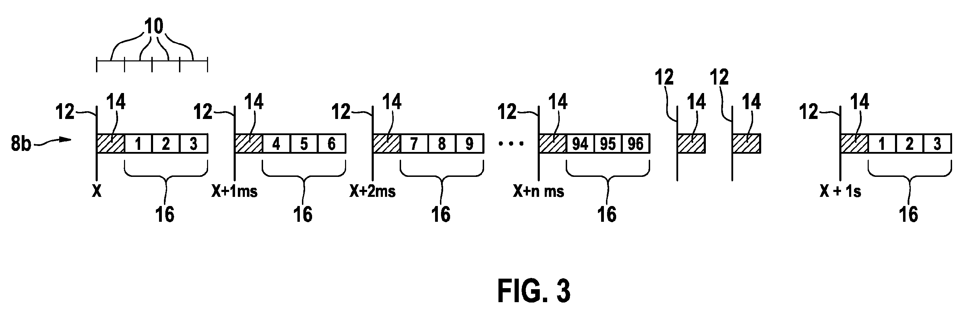

Figur 3 zeigt eine exemplarische Ausgestaltung eines Bussystems, bei dem der Bus exemplarisch jede ms ein Datenpaket übertragen kann, während ein einzelnes Datenpaket aus vier Subpaketen mit Informationen zu Einzelzellen bestehen kann.

Ein Datengesamtpaket 12 besteht somit aus vier Datenpaketen 10, welche gemeinsam über einen Datenbus 8 übertragen werden können. In Figur 3 exemplarisch dargestellt ist eine fokussierte Einzelzelle 4 sowie die zu dieser Einzelzelle 4 gehörenden Messdaten erster Qualität 14. Wie der Figur 3 zu entnehmen, werden Messdaten dieser fokussierten Einzelzelle 4 in jedem Datengesamtpaket 12 für die Dauer von einer Sekunde (X bis X+1s) übertragen. Somit kann das exemplarisch jede ms abgesandte Datengesamtpaket 12 einen aktuellen Messwert der fokussierten Einzelzelle 4 übermitteln, somit Messdaten erster/hoher Qualität. Diese Messdaten können beispielsweise unter Verwendung des Datenbusses 8 an ein BCU-Element 7 weitergegeben werden.

Im Weiteren ermöglicht das Datengesamtpaket 12 die Übermittlung von exemplarisch insgesamt vier Datenpaketen 10, welche das Datengesamtpaket 12 ergeben. Somit können in jedem Datengesamtpaket 12 je ms Messdaten von exemplarisch vier Einzelzellen übertragen werden. Neben der gleichbleibenden Übermittlung von Messdaten hoher Qualität 14 der fokussierten Einzelzelle 4 überträgt der Bus 8 in jedem Datengesamtpaket 12 Messdaten 16 von der weiteren Einzelzellen, welche Messdaten zweiter Qualität darstellen. Die Qualität kann sich hierbei auf die Genauigkeit und/oder die Häufigkeit von übermittelten Messdaten beziehen.
Im ersten Datengesamtpaket 12 zum Zeitpunkt X werden somit neben der fokussierten Einzelzelle 4 Messdaten 16 der weiteren Einzelzellen 1, 2, 3 übertragen. Im Datengesamtpaket 12 zum Zeitpunkt X+1ms werden neben den Messdaten 14 der fokussierten Einzelzelle 4 Messdaten 16 der weiteren Einzelzellen 4, 5, 6 übertragen. Im Datengesamtpaket 12 des Zeitpunktes X+2ms sind dies neben der fokussierten Einzelzelle 4 Datenpakete 16 für die Einzelzellen 7, 8 und 9.

Dies wird exemplarisch fortgesetzt bis zum Datengesamtpaket 12 zum Zeitpunkt X+n ms, wo exemplarisch Messdaten 16 der Einzelzellen 94, 95, 96 übertragen werden. Unter der Annahme, dass die Messdaten zweiter Qualität 16 nur einmal pro Sekunde übermittelt werden sollen, werden im Weiteren exemplarisch in Figur 4 ausschließlich die Messdaten erster Qualität 14 der fokussierten Einzelzelle 4 zwischen den Datengesamtpaketen 12 des Zeitpunktes X+n ms bis zum Zeitpunkt X+1s übertragen. Die verbleibenden möglichen Datenpakete 10 können beispielsweise entfallen. Alternativ kann für die Messdaten zweiter Qualität 16 ein geringeres Raster gewählt werden, so dass sich diese nun, beispielsweise alle ca. 30 ms, wiederholen. Diese Ausgestaltung ist jedoch einer speziellen Implementierung eines Bussystems geschuldet.

In Figur 3 nicht dargestellt sind möglicherweise benötigte Information für Routing und Fehlerkorrektur der Datenpakete.

Die Messdaten erster Qualität bzw. die hochwertigen Messdaten können nachfolgend den Onlineparameteridentifikationalgorithmen eines BCU-Elementes zugeführt werden.
Messdaten zweiter Qualität können anderen Algorithmen, beispielsweise Basisüberwachungsalgorithmen zugeführt werden.

Basisalgorithmen können beispielsweise auch eine State of Charge Ermittlung aufweisen. Unter der Annahme, dass ein Elektromobil in drei Stunden von 100 % State of Charge (Vollladung) leergefahren werden würde, somit eine Entladerate von C/3 aufweisen würde, wären dies 180 Minuten für 100 % State of Charge-Änderung. Würde nun auch nur jede Minute eine State of Charge-Berechnung durchgeführt werden, würde dies bei einer kontinuierlichen Entladung 0,55 % SOC-Änderung je Minute bedeuten. Hierzu wären Basismesswerte mit einem Abtastabstand von einer Sekunde wohl ausreichend. Es könnte damit sogar jede Sekunde eine State of Charge-Ermittlung durchgeführt werden, was regelmäßig jedoch nicht benötigt wird.

Zur Ermittlung einer Leistungsprognose mag jedoch ein 1s-Datenermittlungsabstand nicht ausreichen, da dieser häufig unter anderem Prognosewerte für eine Sekunde an ein Fahrzeugsteuergerät sendet. Eine Möglichkeit besteht hier in der Verwendung eines vorgeschalteten Batteriemodells, das aus schnell abgetasteten Stromwerten eine Spannung ersatzweise berechnen und dadurch die für eine Leistungsprognose benötigten evtl. fehlenden Messwerte ersetzen kann. Dies mag beispielsweise unter Verwendung von Messdaten erster Qualität erfolgen. Bei derart kurzen Zeiträumen zwischen Messwerten mag auch ein einfaches, geeignet parametrisiertes Batteriemodell ausreichend sein.

Die fokussierte Übermittlung von Messdaten einer Einzelzelle, das Cell Focussing Verfahren der vorliegenden Erfindung, reduziert somit die Buslast auf einem Datenbus, insbesondere einem internen Bus 8a zwischen CSC-Elementen 6 eines Batteriemanagementsystems 2, während die Qualität online ermittelter Parameter im Vergleich zu bekannten Lösungen erhöht wird.

Das erfindungsgemäße Verfahren muss hierbei nicht permanent betrieben werden, vielmehr kann ein Batteriemanagementsystem das Verfahren nach definierten Zeiträumen bzw. bei Vorliegen zu überprüfender Messdaten zweiter Qualität auslösen. Das Verfahren kann somit nur bei Bedarf zugeschaltet werden. Bei Einzelspannungsmesschips eines CSC-Elementes können beispielsweise auch mehrere A/D-Wandler vorgesehen sein, wobei einer dieser A/D-Wandler hochtaktend für das erfindungsgemäße Verfahren ausgelegt ist.

## Patentansprüche

1. Verfahren (1) zur Messdaten-Übermittlung von Zellen eines Batteriesystems mit einer Mehrzahl von Einzelzellen, an ein Steuergerät, aufweisend die Schritte bestimmen einer ersten Einzelzelle (4) für die Messdaten mit einer ersten Messdatenqualität (14) bereitgestellt werden sollen;
bestimmen zumindest einer weiteren Einzelzelle (4) für die Messdaten mit einer zweiten Messdatenqualität (16) bereitgestellt werden sollen;
wobei die erste Messdatenqualität höher ist als die zweite Messdatenqualität; bestimmen der Messdaten erster Qualität (14);
bestimmen der Messdaten zweiter Qualität (16);
übertragen der Messdaten erster Qualität unter Verwendung einer Datenverbindung (8) an ein Steuergerät (7); und
übertragen der Messdaten zweiter Qualität (16) nachdem die Messdaten erster Qualität übertragen wurden.

2. Verfahren gemäß dem vorhergehenden Anspruch, wobei die Messdatenqualität die Abtastrate und/oder die Genauigkeit der Messdaten beinhaltet.

3. Verfahren gemäß einem der vorhergehenden Ansprüche,
wobei die Datenübertragung unter Verwendung eines Paketdatenbusses (8) erfolgt; wobei ein Datenpaket (12) die aktuellen Messdaten erster Qualität (14) vollständig aufweist; und
wobei das Datenpaket (12) mit Messdaten zweiter Qualität (16) auffüllbar ist.

4. Verfahren gemäß dem vorhergehenden Anspruch,
wobei eine Mehrzahl von aufeinanderfolgenden Datenpaketen (12) Messdaten erster Qualität (14) der ersten Einzelzelle (4) aufweist; und
wobei die Mehrzahl von aufeinanderfolgenden Datenpaketen (12) Messdaten zweiter Qualität (16) unterschiedlicher weiterer Einzelzellen (4) aufweist, insbesondere aufgefüllt wird.

5. Verfahren gemäß einem der vorhergehenden Ansprüche, wobei die Messdaten Strommessdaten und/oder Spannungsmessdaten einer Einzelzelle (4) beinhalten.

6. Verfahren gemäß einem der vorhergehenden Ansprüche, wobei die Auswahl der ersten Einzelzelle (4) erfolgt basierend auf einem Zeitintervall seit der letzten Messung mit erster Qualität, einer Temperatur der Einzelzelle und einem Messdaten-Wert zweiter Qualität der ersten Einzelzelle, insbesondere einem Strom-Spannungspaar der Einzelzelle und einem Temperaturgradienten der Einzelzelle.

7. Verfahren gemäß einem der vorhergehenden Ansprüche, wobei die Bestimmung von Messdaten erster Qualität (14) durchgeführt wird bis zu einem Zeitlimit und/oder bis zum Erreichen eines Konvergenzkriteriums der Messdaten.

8. Verfahren gemäß einem der vorhergehenden Ansprüche, weiterhin aufweisend den Schritt
wiederholen des Verfahrens (1) gemäß einem der vorhergehenden Ansprüche zur Messwertbestimmung mit erster Qualität für eine der weiteren Einzelzellen (4).

9. Batteriesystem (2), aufweisend ein Steuergerät (7) das eingerichtet ist zum Durchführen des Verfahrens (1) gemäß einem der vorhergehenden Ansprüche.

10. Fahrzeug, insbesondere Elektro- oder Hybridfahrzeug, aufweisend ein Batteriesystem (2) nach dem vorhergehenden Anspruch 9 und/oder ein Steuergerät (7), jeweils eingerichtet zum Durchführen des Verfahrens (1) gemäß einem der Ansprüche 1 bis 8.

## Claims

1. Method (1) for transmitting measurement data from cells of a battery system having a plurality of individual cells to a control device, having the steps of
determining a first individual cell (4) for which measurement data having a first measurement data quality (14) are intended to be provided;
determining at least one further individual cell (4) for which measurement data having a second measurement data quality (16) are intended to be provided;
the first measurement data quality being higher than the second measurement data quality;
determining the measurement data of first quality (14); determining the measurement data of second quality (16) ;
transmitting the measurement data of first quality to a control device (7) using a data connection (8); and transmitting the measurement data of second quality (16) after the measurement data of first quality have been transmitted.

2. Method according to the preceding claim, the measurement data quality comprising the sampling rate and/or the accuracy of the measurement data.

3. Method according to one of the preceding claims,
the data being transmitted using a packet data bus (8);
a data packet (12) completely having the instantaneous measurement data of first quality (14); and
the data packet (12) being able to be filled with measurement data of second quality (16).

4. Method according to the preceding claim,
a plurality of successive data packets (12) having measurement data of first quality (14) from the first individual cell (4); and
the plurality of successive data packets (12) having, in particular being filled with, measurement data of second quality (16) from different further individual cells (4).

5. Method according to one of the preceding claims, the measurement data comprising current measurement data and/or voltage measurement data from an individual cell (4).

6. Method according to one of the preceding claims, the first individual cell (4) being selected on the basis of an interval of time since the last measurement with a first quality, a temperature of the individual cell and a measurement data value of second quality of the first individual cell, in particular a current/voltage pair of the individual cell and a temperature gradient of the individual cell.

7. Method according to one of the preceding claims, measurement data of first quality (14) being determined until a time limit and/or until a convergence criterion of the measurement data is reached.

8. Method according to one of the preceding claims, also having the step of
repeating the method (1) according to one of the preceding claims in order to determine measured values with a first quality for one of the further individual cells (4).

9. Battery system (2) having a control device (7) which is set up to carry out the method (1) according to one of the preceding claims.

10. Vehicle, in particular electric or hybrid vehicle, having a battery system (2) according to the preceding Claim 9 and/or a control device (7), each set up to carry out the method (1) according to one of Claims 1 to 8.

## Revendications

1. Procédé (1) de communication, à un contrôleur, de données de mesure de cellules d'un système de batterie comprenant une pluralité de cellules individuelles, comprenant les étapes suivantes détermination d'une première cellule individuelle (4) pour laquelle des données de mesure doivent être délivrées avec une première qualité de données de mesure (14) ;
détermination d'au moins une cellule individuelle (4) supplémentaire pour laquelle des données de mesure doivent être délivrées avec une deuxième qualité de données de mesure (16) ;
la première qualité de données de mesure étant supérieure à la deuxième qualité de données de mesure ; détermination des données de mesure de la première qualité (14) ;
détermination des données de mesure de la deuxième qualité (16) ;
transmission à un contrôleur (7) des données de mesure de la première qualité en utilisant une liaison de données (8) ; et
transmission des données de mesure de la deuxième qualité (16) après que les données de mesure de la première qualité aient été transmises.

2. Procédé selon la revendication précédente, la qualité des données de mesure incluant la fréquence d'échantillonnage et/ou la précision des données de mesure.

3. Procédé selon l'une des revendications précédentes,
la transmission de données s'effectuant en utilisant un bus de données en paquets (8) ;
un paquet de données (12) possédant entièrement les données de mesure actuelles de la première qualité (14) ; et
le paquet de données (12) pouvant être rempli avec des données de mesure de la deuxième qualité (16).

4. Procédé selon l'une des revendications précédentes,
une pluralité de paquets de données (12) successifs possédant des données de mesure de la première qualité (14) de la première cellule individuelle (4) ; et
la pluralité de paquets de données (12) successifs possédant, étant notamment remplis avec, des données de mesure de la deuxième qualité (16) de cellules individuelles (4) supplémentaires différentes.

5. Procédé selon l'une des revendications précédentes, les données de mesure contenant des données de mesure du courant et/ou des données de mesure de la tension d'une cellule individuelle (4).

6. Procédé selon l'une des revendications précédentes, la sélection de la première cellule individuelle (4) s'effectuant en se basant sur un intervalle de temps depuis la dernière mesure avec la première qualité, une température de la cellule individuelle et une valeur de données de mesure de la deuxième qualité de la première cellule individuelle, notamment d'une paire courant-tension de la cellule individuelle et un gradient de température de la cellule individuelle.

7. Procédé selon l'une des revendications précédentes, la détermination des données de mesure de la première qualité (14) étant effectuée jusqu'à une limite de temps et/ou jusqu'à atteindre un critère de convergence des données de mesure.

8. Procédé selon l'une des revendications précédentes, comprenant en outre l'étape de répétition du procédé (1) selon l'une des revendications précédentes en vue de déterminer une valeur mesurée avec la première qualité pour l'une des autres cellules individuelles (4).

9. Système de batterie (2), comprenant un contrôleur (7) qui est conçu pour mettre en oeuvre le procédé (1) selon l'une des revendications précédentes.

10. Véhicule, notamment véhicule électrique ou hybride, comprenant un système de batterie (2) selon la revendication précédente 9 et/ou un contrôleur (7), respectivement conçu pour mettre en oeuvre le procédé (1) selon l'une des revendications 1 à 8.
